# EUROPEAN PATENT APPLICATION

(11) **EP 2 312 652 A2**
(43) Date of publication of application: **20.04.2011**
(21) Application number: 10187822.1
(22) Date of filing: 15.10.2010
(51) Int. Cl.: H01L 33/08, H01L 33/06

(54) **Light emitting device, light emitting device package and lighting system**

(30) Priority: 19.10.2009 KR 20090099287
(71) Applicant: LG Innotek Co., Ltd., Seoul 100-714 (KR)
(72) Inventor: Son, Hyo Kun, 100-714, SEOUL (KR)
(74) Representative: Cabinet Plasseraud

(57) **Abstract**

A light emitting device according to the embodiment includes a first conductive semiconductor layer; a second conductive semiconductor layer; and an active layer including first and second active layers between the first and second conductive semiconductor layers. The first active layer emits light having a first wavelength band of 440nm to 500nm, and the second active layer emits light having a second wavelength band, which is shorter than the first wavelength band.

## Description

### BACKGROUND

The embodiment relates to a light emitting device, a method of manufacturing the same, a light emitting device package, and a lighting system.

A light emitting diode (LED) is a semiconductor light emitting device that converts current into light. Recently, the brightness of the LED is increased, so that the LED has been employed as a light source for a display device, a vehicle, or a lighting device. In addition, the LED can represent a white color having superior light efficiency by employing phosphors or combining LEDs having various colors.

The wavelength of light emitted from the LED depends on semiconductor material used to manufacture the LED. This is because the wavelength of the emitted light is determined depending on the energy band of an active layer of the LED, that is, depending on the band-gap of the semiconductor material representing energy difference between electrons of a valence band and a conduction band.

Meanwhile, the brightness of the LED is changed according to various conditions such as a structure of an active layer, a light extraction structure for extracting light to the outside, a chip size, and the type of molding members surrounding the LED. If the structure of the active layer is improved, the internal quantum efficiency of the LED can be improved, so that the brightness of the LED can be improved.

### SUMMARY

The embodiment provides a light emitting device capable of improving brightness, a method of manufacturing the same, a light emitting device package, and a lighting system.

The embodiment provides a light emitting device capable of emitting light having various wavelength bands, a method of manufacturing the same, a light emitting device package, and a lighting system.

A light emitting device according to the embodiment includes a first conductive semiconductor layer; a second conductive semiconductor layer; and an active layer including first and second active layers between the first and second conductive semiconductor layers, wherein the first active layer emits light having a first wavelength band of 440nm to 500nm, and the second active layer emits light having a second wavelength band, which is shorter than the first wavelength band.

A method of manufacturing a light emitting device includes the steps of forming a first conductive semiconductor layer; forming an active layer including first and second active layers on the first conductive semiconductor layer; and forming a second conductive semiconductor layer on the active layer, wherein the first active layer emits light having a first wavelength band of 440nm to 500nm, and the second active layer emits light having a second wavelength band, which is shorter than the first wavelength band.

A light emitting device package according to the embodiment includes a light emitting device; a package body for mounting the light emitting device thereon; and an electrode layer electrically connected to the light emitting device. The light emitting device includes a first conductive semiconductor layer, a second conductive semiconductor layer, and an active layer including first and second active layers between the first and second conductive semiconductor layers, in which the first active layer emits light having a first wavelength band of 440nm to 500nm, and the second active layer emits light having a second wavelength band, which is shorter than the first wavelength band;

A lighting system according to the embodiment includes a light emitting module including a substrate and a light emitting device installed on the substrate, wherein the light emitting device includes a first conductive semiconductor layer; a second conductive semiconductor layer; and an active layer including first and second active layers between the first and second conductive semiconductor layers, and wherein the first active layer emits light having a first wavelength band of 440nm to 500nm, and the second active layer emits light having a second wavelength band, which is shorter than the first wavelength band.

### BRIEF DESCRIPTION OF THE DRAWINGS

FIG. 1 is a sectional view showing a light emitting device according to the first embodiment;
FIG. 2A is a sectional view showing an example of an active layer of a light emitting device shown in FIG. 1;
FIG. 2B is a sectional view showing another example of an active layer of a light emitting device shown in FIG. 1;
FIG. 3 is a view showing an energy band of an active layer of a light emitting device shown in FIG. 1;
FIG. 4 is a graph showing brightness according to the wavelength of an active layer of a light emitting device shown in FIG. 1;
FIG. 5 is a graph showing luminous efficiency of a silicate-based phosphor;
FIG. 6 is a sectional view showing a light emitting device according to the second embodiment;
FIG. 7 is a sectional view showing a light emitting device package including a light emitting device according to the embodiment;
FIG. 8 is an exploded perspective view showing a backlight unit including a light emitting device or a light emitting device package according to the embodiment; and
FIG. 9 is a perspective view showing a lighting system including a light emitting device or a light emitting device package according to the embodiment.

### DETAILED DESCRIPTION OF THE EMBODIMENTS

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings.

The thickness and size of each layer shown in the drawings may be exaggerated, omitted or schematically drawn for the purpose of convenience or clarity. In addition, the size of elements does not utterly reflect an actual size.

Hereinafter, a light emitting device, a method of manufacturing the same, a light emitting device package and a lighting system according to the embodiments will be described in detail with reference to accompanying drawings.

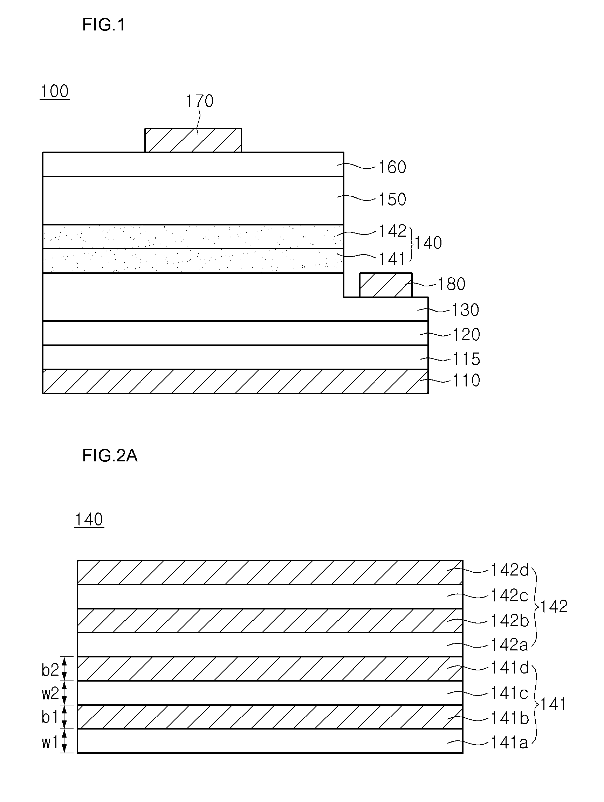

FIG. 1 is a sectional view showing a light emitting device 100 according to the first embodiment.

Referring to FIG. 1, the light emitting device 100 includes a substrate 110, a buffer layer 115, an undoped semiconductor layer 120, a first conductive semiconductor layer 130, an active layer 140 having first and second active layers 141 and 142, a second conductive semiconductor layer 150, a transparent electrode layer 160, a first electrode 180 and a second electrode 170.

The buffer layer 115, the undoped semiconductor layer 120, the first conductive semiconductor layer 130, the active layer 140 and the second conductive semiconductor layer 150 can be formed on the substrate 110 through the CVD (Chemical Vapor Deposition), MBE (Molecular Beam Epitaxy), sputtering, or HVPE (Hydride Vapor Phase Epitaxy) scheme, but the embodiment is not limited thereto.

The substrate 110 may include at least one of sapphire(Al₂O₃), SiC, Si, GaAs, GaN, ZnO, Si, GaP, InP, or Ge.

The buffer layer 115 can be formed on the substrate 110 to attenuate lattice mismatch between the substrate 110 and the first conductive semiconductor layer 130. For instance, the buffer layer 115 may include at least one of GaN, AlN, AlGaN, InGaN, or AllnGaN.

The undoped semiconductor layer 120 can be formed on the buffer layer 115. For instance, the undoped semiconductor layer 120 may include an undoped GaN layer, but the embodiment is not limited thereto.

At least one of the buffer layer 115 or the undoped semiconductor layer 120 can be formed or both the buffer layer 115 and the undoped semiconductor layer 120 can be omitted.

The first conductive semiconductor layer 130 is formed on the undoped semiconductor layer 120. For instance, the first conductive semiconductor layer 130 may include an n type semiconductor layer. The n type semiconductor layer may include semiconductor material having the compositional formula of InₓAlyGa_{1-x-y}N (0≤x≤1, 0 ≤y≤1, 0≤x+y≤1). For instance, the n type semiconductor layer may include may include one selected from the group consisting of InAlGaN, GaN, AlGaN, InGaN, AIN, and InN. In addition, the n type semiconductor layer may be doped with n type dopant, such as Si, Ge or Sn.

In addition, the first conductive semiconductor layer 130 can be formed by injecting trimethyl gallium (TMGa) gas, triethyl gallium (TEGa) gas, ammonia (NH₃) gas, nitrogen (N₂) gas and the n type dopant into the chamber.

The active layer 140 is formed on the first conductive semiconductor layer 130. The active layer 140 includes the first active layer 141 and the second active layer 142 formed on the first active layer 141.

Electrons (or holes) injected through the first conductive semiconductor layer 130 meet holes (or electrons) injected through the second conductive semiconductor layer 150 at the active layer 140, so that the active layer 140 can emit the light based on the band gap of the energy band which is determined according to the material of the active layer 140.

The first active layer 141, for instance, can emit blue light having a first wavelength band of about 440nm to 500nm, and the second active layer 142 can emit UV light having a second wavelength band of about 380nm to less than 440nm.

The active layer 140 may include at least one of a single quantum well structure, a multiple quantum well (MQW) structure, a quantum wire structure or a quantum dot structure.

Referring to FIG. 1, the second active layer 142 is formed on the first active layer 141, but the embodiment is not limited thereto. That is, according to another embodiment, the first active layer 141 can be formed on the second active layer 142.

FIG. 2A is a sectional view showing an example of the active layer 140.

Referring to FIG. 2A, the first active layer 141 may include a plurality of first well layers 141a and 141c and first barrier layers 141b and 141 d. In addition, the second active layer 142 may include a plurality of second well layers 142a and 142c and second barrier layers 142b and 142d.

As shown in FIG. 2A, the first well layers 141a and 141c are stacked alternately with the first barrier layers 141 b and 141 d, and the second well layers 142a and 142c are stacked alternately with the second barrier layers 142b and 142d.

For instance, the first well layers 141 a and 141c of the first active layer 141 can emit blue light having the wavelength band of 440nm to 500nm and may include InₓGa₁₋ₓN (0≤x≤1). In addition, the first barrier layers 141 b and 141d may include In_{y}Ga_{1-y}N (0≤y≤1), in which x and y has relation of y<x.

The first well layers 141 a and 141c may have thickness w1 of about 5Å to 50Å, and the first barrier layers 141 b and 141d may have thickness b1 of about 10Å to 300Å. Thus, a ratio of the thickness b1 of the first barrier layers 141 b and 141d to the thickness w1 of the first well layers 141 a and 141c is about 0.2 to 60, preferably, w1/b1 = 20Å/100Å.

At this time, the growth temperature of the first active layer 141 is about 700°C to 900°C, preferably, about 750°C.

In addition, the second well layers 142a and 142c of the second active layer 142 can emit light having the wavelength band of 380nm to less than 440nm and may include InₓGa₁₋ₓ₁N (0≤x≤1). In addition, the second barrier layers 142b and 142d may include Inₓ₂Al_{y}Ga_{1-x2-y}N (0≤x2≤1, 0≤y≤1, 0≤x2+y≤1), in which x1 and x2 has relation of x2<x1.

The second well layers 142a and 142c may have thickness w2 of about 5Å to 50Å, and the second barrier layers 142b and 142d may have thickness b2 of about 10Å to 300Å. Thus, a ratio of the thickness b2 of the second barrier layers 142b and 142d to the thickness w2 of the second well layers 142a and 142c is about 0.2 to 60, preferably, w2/b2 =15Å/70Å.

At this time, the growth temperature of the second active layer 142 is about 700°C to 900°C, preferably, about 810°C. The growth temperature of the second active layer 142 may be equal to or higher than the growth temperature of the first active layer 141.

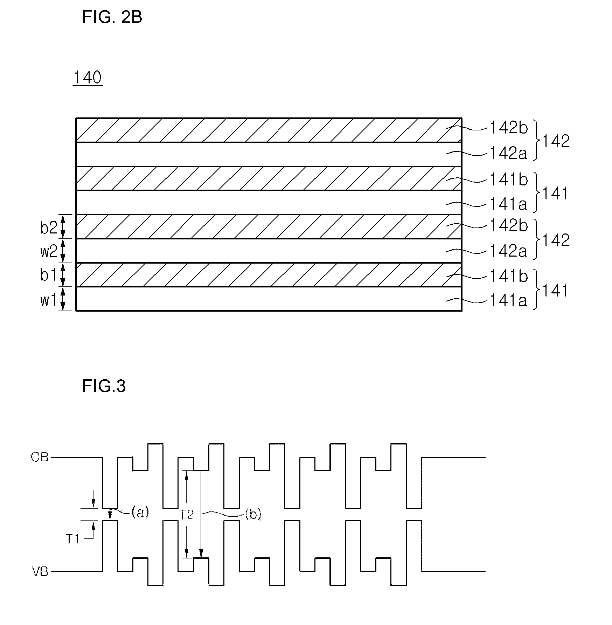

In addition, when the indium content of the second well layers 142a and 142c is set to x1 and the indium content of the first well layers 141 a and 141c is set to x, x and x1 has relation of x1 <x. Since the second barrier layers 142b and 142d may include aluminum (Al), as shown in FIG. 3, the band gap of the second active layer 142 may be greater than the band gap of the first active layer 141.

The light having the second wavelength band emitted from the second active layer 142 may excite the phosphor, for instance, the silicate-based phosphor, so that the brightness of the light emitting device package including the light emitting device and the phosphor can be improved. Although the silicate-based phosphor is preferably employed, the embodiment may not limit the type of the phosphors.

The active layer 140a may include TMGa, TEGa, NH₃, N₂, TMAI or TMln. In addition, the active layer may have the MQW structure including InAlGaN, InGaN or GaN, but the embodiment is not limited thereto.

Although one first active layer 141 and one second active layer 142 have been described in the above embodiments, the number of the first and second active layers 141 and 142 may be changed depending on the design of the light emitting device 100 and the embodiment may not limit the number of the first and second active layers 141 and 142. FIG. 2B is a sectional view showing another example of the active layer 140.

That is, as shown in FIG. 2B, the active layer 140 includes a plurality of first active layers 141 and second active layers 142, which are stacked alternately with each other. Although FIG. 2B shows the first active layer 141 including the well layers 141 a and 142a and the barrier layers 141 b and 142b, the embodiment is not limited thereto. According to another embodiment, the first active layer 141 may include a plurality of first well layers 141 a and first barrier layers 141b, which are stacked alternately with each other, and the second active layer 142 may include a plurality of second well layers 142a and second barrier layers 142b, which are stacked alternately with each other.

The first barrier layer 141b is formed directly on the first well layer 141 a, the second well layer 142a is formed directly on the first barrier layer 141b, and the second barrier layer 142b is formed directly on the second well layer 142a.

Hereinafter, the operational principle of the active layer 140 will be described in detail with reference to FIGS. 3 to 5.

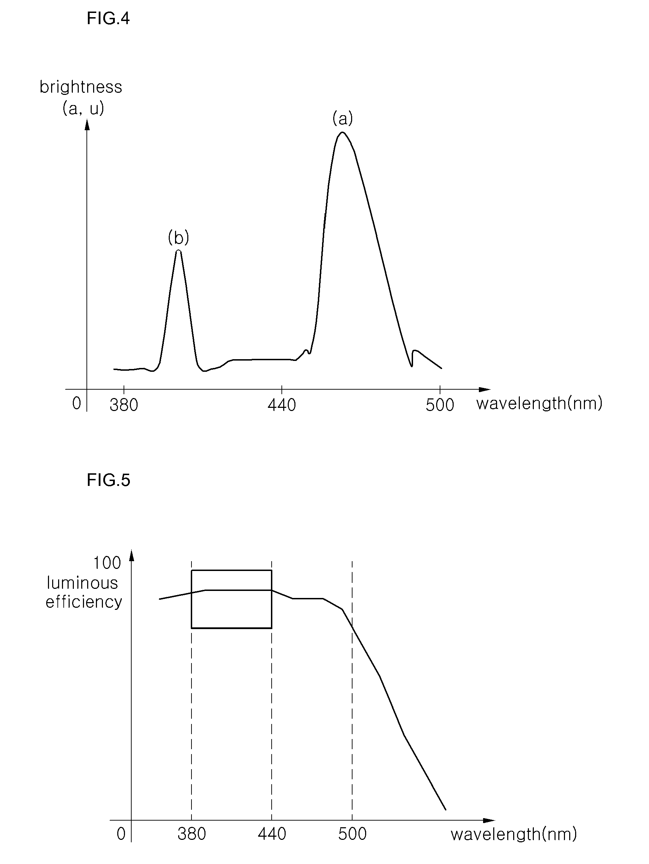

FIG. 3 is a view showing an energy band of the active layer 140, FIG. 4 is a graph showing brightness according to the wavelength of the active layer 140, and FIG. 5 is a graph showing luminous efficiency of a silicate-based phosphor. As an example, the energy band of the active layer 140 shown in FIG. 2B is illustrated in FIG. 3.

Referring to FIG. 3, the energy band of the active layer 140 includes the valence band VB and the conduction band CB.

Electrons of the active layer 140 may belong to one of the valence band VB and the conduction band CB. The electrons having stable energy may belong to the valence band VB and the electrons excited by external energy may belong to the conduction band CB. The electrons belonging to the conduction band CB return to the valence band VB while generating energy, so that the light is emitted. At this time, the wavelength of the light is determined based on the band gap of the energy band of the conduction band CB and the valence band VB.

A first light (a) can be emitted from the first active layer 141 when the energy band of the conduction band CB and the valence band VB has a first gap T1, and a second light (b) can be emitted from the second active layer 142 when the energy band of the conduction band CB and the valence band VB has a second gap T2 larger than the first gap T1.

As described above, the first light (a) emitted from the first active layer 141 may have the first wavelength band of 440nm to 500nm, and the second light (b) emitted from the second active layer 142 may have the second wavelength band of 380nm to less than 440nm. That is, since the first gap T1 is smaller than the second gap T2, the first wavelength band is larger than the second wavelength band.

At this time, the energy band of the conduction band CB and the valence band VB may be determined according to the material of the active layer 140. Since the first and second active layers 141 and 142 can be formed by using different materials, the active layer 40 may emit the light including the first light (a) having the first wavelength band and the second light (b) having the second wavelength band.

In addition, FIG. 3 represents the energy band of the active layer 140 including the first and second active layers 141 and 142, which are stacked alternately with each other. The energy band may be changed depending on the stack structure of the active layer 140, and the embodiment is not limited thereto.

Referring to FIG. 4, the first light (a) may have the peak wavelength in the first wavelength band of about 440nm to 500nm, and the second light (b) may have the peak wavelength in the second wavelength band of about 380nm to less than 440nm. Meanwhile, the brightness may be changed depending on the material of the active layer 140 and the embodiment is not limited to the brightness distribution shown in FIG. 4.

Hereinafter, the luminous efficiency according to the wavelength of the silicate-based phosphor will be described with reference to FIG. 5. The phosphor has the superior luminous efficiency in the first wavelength band of 440nm to 500nm as well as in the second wavelength band of 380nm to less than 440nm. Thus, the phosphor is excited by the first light (a) emitted from the first active layer 141 and excited by the second light (b) emitted from the second active layer 142 so that the phosphor emits the light. In more detail, a part of the first light (a), which is the blue light, excites the phosphor to allow the phosphor to emit yellow light and the remaining part of the first light (a) is realized as the blue light. In addition, the second light (b) having the wavelength band of 380nm to less than 440nm excites the phosphor to allow the phosphor to emit the yellow light. That is, the first light (a) excites the phosphor and is mixed with the light emitted from the phosphor to generate white light. In contrast, the second light (b) excites the phosphor without being mixed with the light emitted from the phosphor so as to improve the luminous efficiency of the yellow light.

According to the embodiment, the phosphor can be excited by the blue light having the wavelength band of 440nm to 500nm and by the light having the short wavelength band of 380nm to less than 440nm, so that the luminous efficiency of the phosphor can be improved. Referring to FIG. 5, the luminous efficiency in the second wavelength band of 380nm to less than 440nm is slightly higher than the luminous efficiency in the first wavelength band of 440nm to 500nm, so that the luminous efficiency can be effectively improved. Thus, the light emitting device package having superior brightness can be provided by using the light emitting device 100 including the first and second active layers 141 and 142, and the phosphor.

The second conductive semiconductor layer 150 is formed on the active layer 140. For instance, the second conductive semiconductor layer 150 may include a p type semiconductor layer. The p type semiconductor layer may include semiconductor material having the compositional formula of InₓAl_{y}Ga_{1-x-y}N (0≤x≤1, 0≤y≤1, 0≤x+y≤1). In detail, the p type semiconductor layer may include one selected from the group consisting of InAlGaN, GaN, AlGaN, InGaN, AIN, and InN and can be doped with p type dopant, such as Mg.

In addition, the second conductive semiconductor layer 150 can be formed by injecting trimethyl gallium (TMGa) gas, ammonia (NH₃) gas, nitrogen (N₂) gas and the p type dopant into the chamber, but the embodiment is not limited thereto.

According to the embodiment, the first active layer 141 adjacent to the first conductive semiconductor layer 130, which is the n type semiconductor layer, may emit the light having the first wavelength band of 440nm to 500nm, and the second active layer 142 adjacent to the second conductive semiconductor layer 150, which is the p type semiconductor layer, may emit the light having the second wavelength band of 380nm to less than 440nm, but the embodiment is not limited thereto.

Therefore, the p type dopant and the n type dopant can be doped in the first and second conductive semiconductor layers 130 and 150, respectively, but the embodiment is not limited thereto. In addition, although not shown in the drawings, a third conductive semiconductor layer (not shown) can be formed on the second conductive semiconductor layer 150. Thus, the light emitting device 100 may have one of the pn, np, pnp and npn junction structures. The transparent electrode layer 160 is formed on the second conductive semiconductor layer 150. The transparent electrode layer 160 may include at least one selected from the group consisting of ITO, IZO(In-ZnO), GZO(Ga-Zn0), AZO(Al-ZnO), AGZO(Al-Ga ZnO), IGZO(ln-Ga ZnO), IrOₓ, RuOx, RuOx/ITO, Ni/IrO,/Au, or Ni/IrOₓ/Au/ITO, but the embodiment is not limited thereto.

The second electrode 170 is formed on the transparent electrode layer 160 and the first electrode 180 is formed on the first conductive semiconductor layer 130. At this time, the mesa etching is performed to expose the first conductive semiconductor layer 130 and the first electrode 180 is formed on the exposed first conductive semiconductor layer 130. The first and second electrodes 170 and 180 supply power to the light emitting device 100.

Hereinafter, the method of manufacturing a light emitting device 100B according to the second embodiment will be described. The same reference numerals will be assigned to the same elements and description about the elements and structures that have already been explained in the first embodiment will be omitted in order to avoid redundancy.

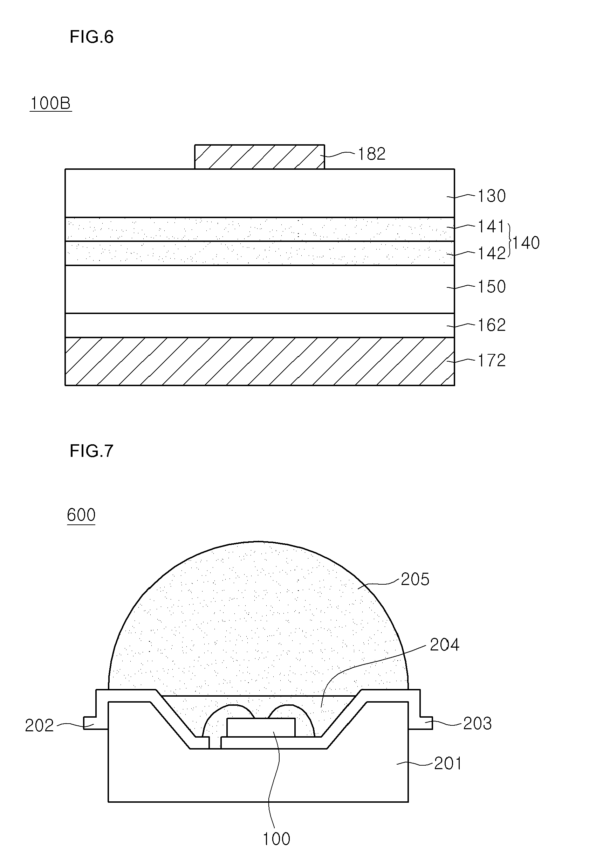

FIG. 6 is a sectional view showing the light emitting device 100B according to the second embodiment.

Referring to FIG. 6, the light emitting device 100B includes the first conductive semiconductor layer 130, the active layer 140 having the first active layer 141 and the second active layer 142, the second conductive semiconductor layer 150, a reflective layer 162, a conductive support member 172, and a first electrode 182.

The light emitting device 100B is a vertical type light emitting device in which the conductive support member 172 and the first electrode 182 are provided on bottom and top surfaces thereof, respectively. The light emitting device 100B can be obtained by forming the reflective layer 162 and the conductive support member 172 on second conductive semiconductor layer 150 after removing the substrate 110 from the light emitting device 100 shown in FIG. 1.

The substrate 110 can be removed through the laser lift off process or the etching process, but the embodiment is not limited thereto.

As the substrate 110 is removed, surfaces of the buffer layer 115, the undoped semiconductor layer 120, and the first conductive semiconductor layer 130 may be exposed and the exposed surfaces are polished through the ICP/RIE (Inductively coupled Plasma/Reactive Ion Etching) process.

The buffer layer 115, the undoped semiconductor layer 120, and the first conductive semiconductor layer 130 may be partially or completely removed.

The reflective layer 162 is formed on the second conductive semiconductor layer 150. The reflective layer 162 may include at least one selected from the group consisting Ag having high reflectivity, an Ag alloy, Al or an Al alloy.

The conductive support member 172 may include at least one selected from the group consisting of Ti, Cr, Ni, Al, Pt, Au, W, Cu, Mo, or semiconductor material doped with impurities. The conductive support member 172 supplies power to the light emitting device 100B together with the first electrode 182.

FIG. 7 is a sectional view showing a light emitting device package 600 including the light emitting device 100 and the phosphor according to the embodiment. Although the light emitting device package 600 includes the light emitting device 100 according to the first embodiment, the light emitting device 100B according to the second embodiment can also be used for the light emitting device package 600.

The light emitting device package 600 includes a package body 201, first and second electrode layers 202 and 203 formed on the package body 201, the light emitting device 100 and a molding member 204.

The package body 201 may include silicon, synthetic resin or metallic material and have a cavity with an inclined sidewall.

The first and second electrode layers 202 and 203 are electrically isolated from each other to supply power to the light emitting device 100. In addition, the first and second electrode layers 202 and 203 reflect the light emitted from the light emitting device 100 to improve the light efficiency and dissipate heat generated from the light emitting device 100 to the outside.

The light emitting device 100 can be installed on the package body 201 or the first and second electrode layers 202 and 203.

The light emitting device 100 is electrically connected to the first ands second electrode layers 202 and 203through at least one of a wire bonding scheme, a flip chip bonding scheme or a die bonding scheme. According to the embodiment, the first and second electrodes 180 and 170 of the light emitting device 100 are electrically connected to the first and second electrode layers 202 and 203 through a wire, respectively, but the embodiment is not limited thereto. For instance, the light emitting device 100 can be connected to the first electrode layer 202 through the wire and electrically connected to the second electrode layer 203 through the die bonding scheme.

The molding member 204 surrounds the light emitting device 100 to protect the light emitting device 100.

The light emitting device package 600 may further include a lens 205. The lens 205 is provided on the body 201 to adjust distribution of the light emitted from the light emitting device package 600.

At least one of the molding member 204 or the lens 205 may include the phosphor.

Since the light emitted from the light emitting device includes the first light (a) having the first wavelength band and the second light (b) having the second wavelength band, the light excites the phosphor provided in the molding member 204 or the lens 205 to adjust the color of the light emitted from the light emitting device package 600 while improving the brightness of the light.

In particular, the second light (b) having the second wavelength band can effectively excite the phosphor, so that the brightness of the light emitted from the light emitting device package 600 can be improved.

A plurality of light emitting device packages according to the embodiment may be arrayed on a substrate, and an optical member including a light guide plate, a prism sheet, a diffusion sheet or a fluorescent sheet may be provided on the optical path of the light emitted from the light emitting device package. The light emitting device package, the substrate, and the optical member may serve as a backlight unit or a lighting system. For instance, the lighting system may include a backlight unit, a lighting unit, an indicator, a lamp or a streetlamp.

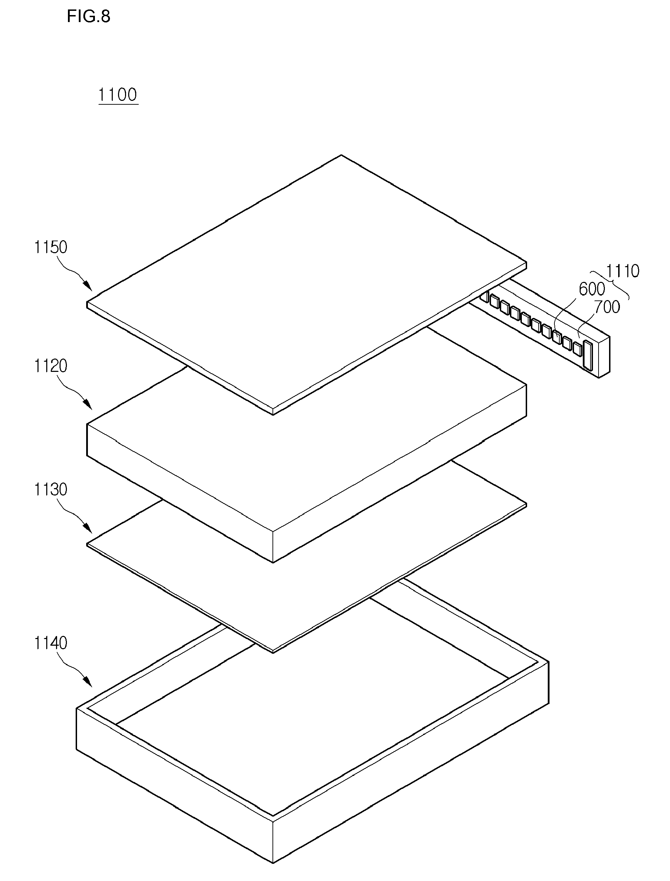

FIG. 8 is an exploded perspective view showing a backlight unit 1100 including the light emitting device or the light emitting device package according to the embodiment. The backlight unit 1100 shown in FIG. 8 is an example of a lighting system and the embodiment is not limited thereto.

Referring to FIG. 8, the backlight unit 1100 includes a bottom cover 1140, a light guide member 1120 installed in the bottom cover 1140, and a light emitting module 1110 installed at one side or on the bottom surface of the light guide member 1120. In addition, a reflective sheet 1130 is disposed under the light guide member 1120.

The bottom cover 1140 has a box shape having a top surface being open to receive the light guide member 1120, the light emitting module 1110 and the reflective sheet 1130 therein. In addition, the bottom frame may include metallic material or resin material, but the embodiment is not limited thereto.

The light emitting module 1110 may include a substrate 700 and a plurality of light emitting device packages 600 installed on the substrate. The light emitting device packages 600 provide the light to the light guide member 1120. According to the embodiment, the light emitting module 1110 includes the light emitting packages 600 installed on the substrate 700. However, it is also possible to directly install the light emitting device.

As shown in FIG. 8, the light emitting module 1110 is installed on at least one inner side of the bottom frame 1140 to provide the light to at least one side of the bottom cover 1140.

In addition, the light emitting module 1110 can be provided under the bottom cover 1140 to provide the light toward the bottom surface of the light guide member 1120. Such an arrangement can be variously changed according to the design of the backlight unit 1100 and the embodiment is not limited thereto.

The light guide member 1120 is installed in the bottom cover 1140. The light guide member 1120 converts the light emitted from the light emitting module 1110 into the surface light to guide the surface light toward a display panel (not shown).

The light guide member 1120 may include a light guide plate. For instance, the light guide plate can be manufactured by using acryl-based resin, such as PMMA (polymethyl methacrylate), PET (polyethylene terephthalate), PC (polycarbonate), COC or PEN (polyethylene naphthalate) resin.

An optical sheet 1150 may be provided over the light guide member 1120.

The optical sheet 1150 may include at least one of a diffusion sheet, a light collection sheet, a brightness enhancement sheet, or a fluorescent sheet. For instance, the optical sheet 1150 has a stack structure of the diffusion sheet, the light collection sheet, the brightness enhancement sheet, and the fluorescent sheet. In this case, the diffusion sheet uniformly diffuses the light emitted from the light emitting module 1110 such that the diffused light can be collected on the display panel by the light collection sheet. The light output from the light collection sheet is randomly polarized and the brightness enhancement sheet increases the degree of polarization of the light output from the light collection sheet. The light collection sheet may include a horizontal and/or vertical prism sheet. In addition, the brightness enhancement sheet may include a dual brightness enhancement film and the fluorescent sheet may include a transmittive plate or a transmittive film including phosphors.

The reflective sheet 1130 can be disposed under the light guide member 1120. The reflective sheet 1130 reflects the light, which is emitted through the bottom surface of the light guide member 1120, toward the light exit surface of the light guide member 1120.

The reflective sheet 1130 may include resin material having high reflectivity, such as PET, PC or PVC resin, but the embodiment is not limited thereto.

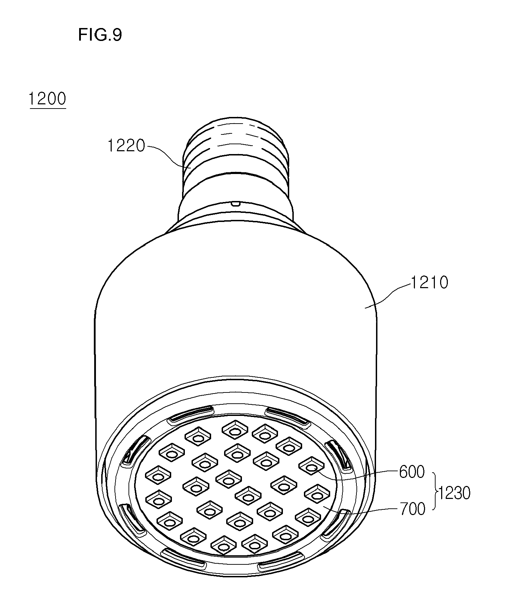

FIG. 9 is a perspective view showing a light system 1200 including the light emitting device or the light emitting device package according to the embodiment. The lighting system 1200 shown in FIG. 9 is for illustrative purposes and the embodiment is not limited thereto.

Referring to FIG. 9, the lighting system 1200 includes a case body 1210, a light emitting module 1230 installed in the case body 1210, and a connection terminal 1220 installed in the case body 1210 to receive power from an external power source.

Preferably, the case body 1210 includes material having superior heat dissipation property. For instance, the case body 1210 includes metallic material or resin material.

The light emitting module 1230 may include a substrate 700 and at least one light emitting device package 600 installed on the substrate 700. According to the embodiment, the light emitting module 1110 includes the light emitting packages 600 installed on the substrate 700. However, it is also possible to directly install the light emitting device 100.

The substrate 700 includes an insulating member printed with a circuit pattern. For instance, the substrate 700 includes a PCB (printed circuit board), an MC (metal core) PCB, an F (flexible) PCB, or a ceramic PCB.

In addition, the substrate 700 may include material that effectively reflects the light. The surface of the substrate 300 can be coated with a color, such as a white color or a silver color, to effectively reflect the light.

At least one light emitting device package 600 according to the embodiment can be installed on the substrate 700. Each light emitting device package 600 may include at least one LED (light emitting diode). The LED may include a colored LED that emits the light having the color of red, green, blue or white and a UV (ultraviolet) LED that emits UV light.

The LEDs of the light emitting module 1230 can be variously arranged to provide various colors and brightness. For instance, the white LED, the red LED and the green LED can be arranged to achieve the high color rendering index (CRI). In addition, a fluorescent sheet can be provided in the path of the light emitted from the light emitting module 1230 to change the wavelength of the light emitted from the light emitting module 1230. For instance, if the light emitted from the light emitting module 1230 has a wavelength band of blue light, the fluorescent sheet may include yellow phosphors. In this case, the light emitted from the light emitting module 1230 passes through the fluorescent sheet so that the light is viewed as white light.

The connection terminal 1220 is electrically connected to the light emitting module 1230 to supply power to the light emitting module 1230. Referring to FIG. 9, the connection terminal 1220 has a shape of a socket screw-coupled with the external power source, but the embodiment is not limited thereto. For instance, the connection terminal 1220 can be prepared in the form of a pin inserted into the external power source or connected to the external power source through a wire.

According to the lighting system as mentioned above, at least one of the light guide member, the diffusion sheet, the light collection sheet, the brightness enhancement sheet or the fluorescent sheet is provided in the path of the light emitted from the light emitting module, so that the desired optical effect can be achieved.

As described above, the lighting system may include the light emitting device or the light emitting device package capable of lowering the operational voltage while improving the light efficiency, so that the light efficiency and the reliability of the lighting system can be improved.

The embodiment can provide the light emitting device capable of improving the brightness, the method of manufacturing the same, the light emitting device package, and the lighting system.

The embodiment can provide the light emitting device and the method of manufacturing the same, in which the light emitting device can emit the light having various wavelength bands by adjusting the composition of In and Al in the active layer, the thickness of the active layer and the growth temperature of the active layer.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting device comprising:
a first conductive semiconductor layer;
a second conductive semiconductor layer; and
an active layer including first and second active layers between the first and second conductive semiconductor layers,
wherein the first active layer emits light having a first wavelength band of 440nm to 500nm, and the second active layer emits light having a second wavelength band, which is shorter than the first wavelength band.

2. The light emitting device as claimed in claim 1, wherein the second active layer is formed on the first active layer, or the first active layer is formed on the second active layer.

3. The light emitting device as claimed in claim 1, wherein the first active layer includes a plurality of first active layers, the second active layer includes a plurality of second active layers, and the first and second active layers are stacked alternately with each other.

4. The light emitting device as claimed in claim 1, wherein the second wavelength band is in the range of 380nm to less than 440nm.

5. The light emitting device as claimed in claim 1, wherein the first active layer includes a plurality of first well layers and first barrier layers alternately aligned with the first well layers, and the second active layer includes a plurality of second well layers and second barrier layers alternately aligned with the second well layers.

6. The light emitting device as claimed in claim 5, wherein a ratio of a thickness of each first barrier layer to a thickness of each first well layer is about from 0.2 to 60.

7. The light emitting device as claimed in claim 5, wherein a ratio of a thickness of each second barrier layer to a thickness of each second well layer is about from 0.2 to 60.

8. The light emitting device as claimed in claim 5, wherein the second well layers include Inₓ₁Ga₁₋ₓ₁N (0≤x1≤1), and the second barrier layers include Inₓ₂Al_{y}Ga_{1-x2-y}N (0≤x2≤1, 0≤y≤1, 0≤x2+y≤1), in which x1 and x2 has relation of x2<x1.

9. The light emitting device as claimed in claim 5, wherein the first well layers include Inₓ₁Ga₁₋ₓN (0≤x1≤1), and the first barrier layers include In_{y}Ga_{1-y}N (0≤y≤1), in which x and y has relation of y<x.

10. The light emitting device as claimed in claim 5, wherein the second well layers include Inₓ₁Ga₁₋ₓ₁N (0≤x1≤1), and the first well layers include InₓGa₁₋ₓN (0≤x≤1), in which x1 and x has relation of x1<x.

11. The light emitting device as claimed in claim 1, further comprising a substrate under the first conductive semiconductor layer.

12. The light emitting device as claimed in claim 11, further comprising at least one of a buffer layer or an undoped semiconductor layer between the first conductive semiconductor layer and the substrate.

13. The light emitting device as claimed in claim 1, further comprising a conductive support member under the second conductive semiconductor layer.

14. A light emitting device package comprising:
a light emitting device as claimed in one of claims 1 to 13;
a package body for mounting the light emitting device thereon; and
an electrode layer electrically connected to the light emitting device.

15. A lighting system comprising:
a light emitting module including a substrate and a light emitting device as claimed in one of claims 1 to 13 installed on the substrate.
